# EUROPEAN PATENT APPLICATION

(11) **EP 3 396 708 A1**
(43) Date of publication of application: **31.10.2018**
(21) Application number: 16878360.3
(22) Date of filing: 07.12.2016
(51) Int. Cl.: H01L 21/683, B23Q 3/08

(54) **SUBSTRATE SUCTIONING DEVICE**

(30) Priority: 25.12.2015 JP 2015253297
(71) Applicant: Mitsuboshi Diamond Industrial Co., Ltd., Settsu Osaka 566-0034 (JP)
(72) Inventor: HORII, Ryogo, Settsu city Osaka 566-0034 (JP); NOZAKI, Masakazu, Settsu city Osaka 566-0034 (JP)
(74) Representative: TBK
(86) International application number: PCT/JP2016/086321
(87) International publication number: WO 2017/110467

(57) **Abstract**

An objective of the present invention is to stably suck various kinds of deflected substrates and hold such substrates to a work table. A substrate suction device (30) is attachable to and detachable from each of a plurality of holes (15b) formed in a work table (10). The substrate suction device (30) includes a flange member (31), a cylinder (32), and a coil spring (33). The flange member (31) is provided with a housing portion (31a) that is formed inside thereof and is open upward, has a communication hole (31c) that is formed in a bottom of the housing portion (31a) and is in communication with a suction source, and is attachable to and detachable from a hole (15b) formed in the work table (10). The cylinder (32) is located in the housing portion (31a) of the flange member (31) so as to be movable in a vertical direction within a predetermined range, and has a suction hole (32a) that is formed inside thereof and penetrates through the flange member (31) in the vertical direction. The coil spring (33) biases the cylinder (32) upward so that an upper end surface of the cylinder (32) protrudes from the mounting surface of the work table (10) by a predetermined amount.

## Description

### Technical Field

The present invention relates to a substrate suction device, and particularly to a substrate suction device that is attachable to and detachable from each of a plurality of holes formed in a work table. The present invention also relates to a work table.

### Background Art

In a substrate manufacturing process, a substrate that is to be processed needs to be fixed to a work table. Typically, various elements are formed on the top surface of a substrate. Thus, it is impossible to fix a substrate to a work table by abutting a pressing member against the top surface of the substrate and pressing the substrate toward the work table.

Therefore, as shown in Patent Document 1, for example, a substrate suction device for sucking the back surface of a substrate to fix the substrate to a work table is used. In the substrate suction device according to Patent Document 1, a communication hole that is in communication with the internal space of the work table is formed in a portion of the work table, and a supporting portion is positioned to be slidable in a vertical direction along the communication hole. Also, a suction pad that has a suction hole is provided on top of the supporting portion. The device according to Patent Document 1 is configured to fix a substrate to a mounting surface of the work table by drawing the substrate mounted on the work table toward the work table while sucking the substrate using the suction pad.

### Citation List

### Patent Document

Patent Document 1: JP2012-146783A

### Summary of Invention

### Technical Problem

The device according to Patent Document 1 can suck a substrate and fix the substrate to the work table even if the substrate is deflected due to warping or the like.

However, substrates that are to be mounted on the work table are deflected by different amounts because the degree of warping and undulation varies for each substrate, depending on what was performed in processing performed in previous steps, the shape of the substrate, and so on. Therefore, it is preferable that suction conditions such as the configuration and suction power of the suction pad can be changed according to the degree of deflection.

Also, in a case where a substrate is sucked at a plurality of positions using the substrate suction device according to Patent Document 1, portions sucked by the suction device are held in intimate contact with the work table, while other portions may be held in a state of being raised above the work table due to warping or undulation. If a substrate is processed in such a state, processing quality may be degraded.

One objective of the present invention is to stably suck various kinds of deflected substrates and hold such substrates to a work table.

Another objective of the present invention is to fix the entirety of a deflected substrate to a work table by sucking such a substrate, to prevent processing quality from being degraded.

### Solution to Problem

(1) A substrate suction device according to the present invention is a device that is attachable to and detachable from each of a plurality of holes formed in a work table, and is used to suck a substrate mounted on the work table. The suction device includes a flange member, a cylinder, and a biasing means. The flange member is provided with a housing portion that is formed inside thereof and is open upward, has a communication hole that is formed in a bottom of the housing portion and is in communication with a suction source, and is attachable to and detachable from a hole formed in the work table. The cylinder is located in the housing portion of the flange member so as to be movable in a vertical direction within a predetermined range, and has a suction hole that is formed inside thereof and penetrates through the flange member in the vertical direction. The biasing means biases the cylinder upward so that an upper end surface of the cylinder protrudes from a mounting surface of the table by a predetermined amount.

With this device, when a substrate is mounted on the work table, the leading end of the cylinder abuts against the back surface of the substrate. The cylinder is movable in the vertical direction, and is also biased upward by the biasing means. Therefore, even if the substrate is deflected due to warping, undulation, or the like, the leading end of the cylinder comes into intimate contact with the substrate. In this state, the internal spaces of the cylinder and the flange member are depressurized, and thus the substrate is pressed against the leading end of the cylinder due to atmospheric pressure. Upon the substrate being drawn downward (i.e. being sucked), the cylinder moves downward opposing the biasing force of a coil spring. The substrate is drawn downward while being sucked by the cylinder, to abut against the mounting surface of the work table.

Here, the degree of deflection of a substrate varies depending on what was performed in processing performed in previous steps, and substrates differ from each other in shape such as thickness. Therefore, if suction conditions (specifications for suction) are constant and fixed, there are cases where it is impossible to stably suck and hold a substrate.

Thus, the present invention is configured such that the flange member is attachable to and detachable from a hole that is formed in the work table, and the entirety of the suction device including the flange member can be easily replaced as a unit. Therefore, it is possible to suck and fix a substrate to the work table under optimum conditions according to the degree of deflection of the substrate, the shape of the substrate, and so on. Therefore, it is possible to stably hold a substrate to the work table, and process the substrate.
(2) Preferably, the cylinder includes a cylinder body that is made of metal, and an abutting member that is made of resin. The abutting member is attached to a top portion of the cylinder body, and abuts against a workpiece that is to be mounted on the work table.

Here, the abutting member that is made of resin abuts against a substrate, and therefore, by forming the abutting member using a resin that has a small coefficient of friction with substrates, for example, it is possible to make a substrate be less likely to be restrained from moving in a horizontal direction. Also, by forming the abutting member using a resin that has excellent abrasion resistance, it is possible to increase the lifespan of the cylinder.
(3) Preferably, the flange member is made of metal. Also, a gap between an inner circumferential surface of the housing portion of the flange member and an outer circumferential surface of the cylinder body is no greater than 50 µm.

When suction is performed, the internal space of the flange member, in which the cylinder is housed, is depressurized. Here, the cylinder is movable relative to the flange member, and therefore, if the gap between them is too large, external air is sucked via the gap, and a substrate cannot be sufficiently sucked.

Thus, in the present invention, the gap between the inner circumferential surface of the housing portion of the flange member and the outer circumferential surface of the cylinder body is no greater than 50 µm. Therefore, it is possible to achieve sufficient suction force.
(4) Preferably, the device further includes a restriction mechanism that restricts an amount of protrusion of the upper end surface of the cylinder protruding from the mounting surface of the work table.
(5) Preferably, the restriction mechanism includes a hole and a pin. The hole is formed in the cylinder and has a predetermined length in the vertical direction. The pin is provided in the flange member and abuts against upper and lower end surfaces of the hole when the cylinder moves upward and downward.
(6) A work table according to another aspect of the present invention is provided for a substrate processing device. A substrate that is to be processed is mounted on the work table. The substrate processing device sucks and holds the substrate mounted on the work table. The work table includes a table body and movable suction devices. The table body has a top surface in which grooves that are in communication with a suction source are formed, and is configured to suck and hold a substrate to a mounting surface thereof via the grooves. The movable suction devices each include a cylinder that is movable in a vertical direction such that an upper end surface of the cylinder protrudes from the mounting surface of the table body and is configured to suck a substrate, and are respectively located at a plurality of positions of the table body.

Upon a deflected substrate being conveyed onto the work table, the movable suction devices provided at a plurality of positions of the work table suck the substrate. Then, the cylinders of the movable suction devices move downward, and thus the substrate is mounted on the mounting surface of the work table.

Thereafter, the entirety of the substrate is sucked via the grooves formed in the table body. Thus, the entirety of the substrate can be brought into intimate contact with the work table, and held to the work table. Therefore, even if a deflected substrate is conveyed, it is possible to uniformly process the entirety of the substrate, and it is possible to prevent processing quality from being degraded.
(7) Preferably, the grooves in the table body are formed so as to surround the movable suction devices.
(8) Preferably, holes are formed in the table body. Also, each suction device includes a flange member, a cylinder, and a biasing means. The flange member is provided with a housing portion that is formed inside thereof and is open upward, has a communication hole that is formed in a bottom of the housing portion and is in communication with a suction source, and is attachable to and detachable from a hole formed in the table body. The cylinder is located in the housing portion of the flange member so as to be movable in a vertical direction within a predetermined range, and has a suction hole that is formed inside thereof and penetrates through the flange member in the vertical direction. The biasing means biases the cylinder upward so that an upper end surface of the cylinder protrudes from a mounting surface of the table body by a predetermined amount.

### Advantageous Effects of the Invention

With the above-described substrate suction device according to the present invention, it is possible to stably suck various kinds of deflected substrates and hold such substrates to a work table. Also, with a work table according to the present invention, it is possible to fix the entirety of a deflected substrate to the work table by sucking such a substrate, and prevent processing quality from being degraded.

### Brief Description of Drawings

FIG. 1 is a plan view of a work table according to an embodiment of the present invention.
FIG. 2 is a cross-sectional view of a substrate suction device according to an embodiment of the present invention.

### Description of Embodiments

### Configurations

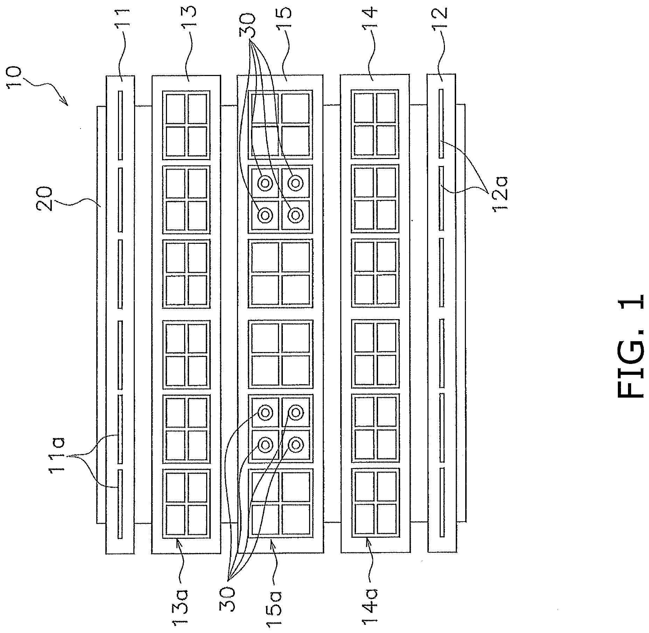

FIG. 1 is a plan view of a work table 10 according to an embodiment of the present invention. The work table 10 includes one base plate 20 and first to fifth mounting platforms 11 to 15 that are fixed on top of the base plate 20.

The first and second mounting platforms 11 and 12 are located at two ends, and have the narrowest width. A plurality of elongated grooves 11a and 12a are formed in the surface of each of the first and second mounting platforms 11 and 12. The third and fourth mounting platforms 13 and 14 are located inward of the first and second mounting platforms 11 and 12, and have a wider width than the first and second mounting platforms 11 and 12. A plurality of grid-shaped groove sets 13a and a plurality of grid-shaped groove sets 14a, each consisting of a rectangular groove and a "+" shaped groove that divides an area inside the rectangle, are respectively formed in the surfaces of the third and fourth mounting platforms 13 and 14. A rectangular groove and the groove inside the rectangular groove are in communication with each other. The fifth mounting platform 15 is located in a central area. The fifth mounting platform 15 has the widest width. A plurality of elongated grooves 15a, which are similar to those in the third and fourth mounting platforms 13 and 14, are formed in the surface of fifth mounting platform 15.

Note that the grooves 11a to 15a formed in the mounting platforms 11 to 15 are connected to a suction source (e.g. a vacuum pump) (not shown) via one shared suction system.

In two groove sets 15a out of the six groove sets 15a formed in the fifth mounting platform 15, movable suction devices 30 are respectively located in the four areas surrounded by the grooves.

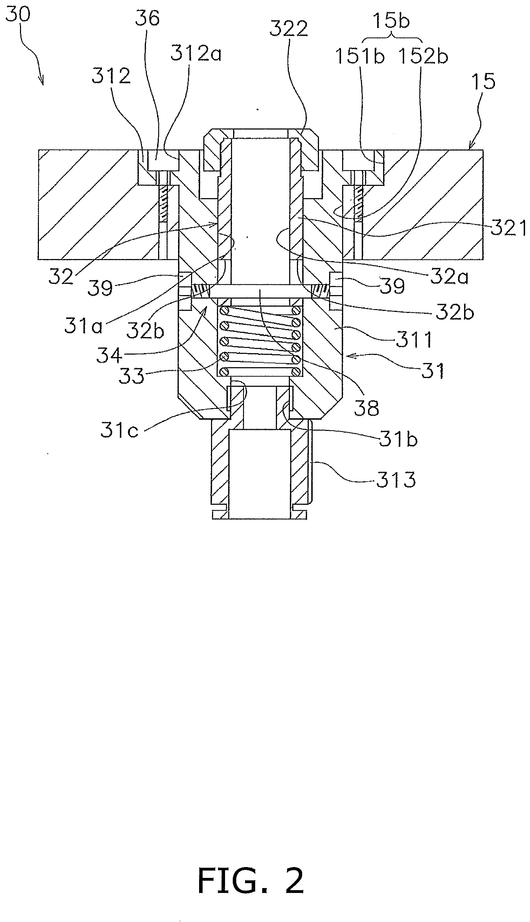

FIG. 2 shows a cross section of a movable suction device 30. The fifth mounting platform 15 is provided with a through hole 15b that has a step-like portion and penetrates through the fifth mounting platform 15 in a vertical direction. That is, the through hole 15b includes a first hole 151b that is formed on the surface side and has a large diameter, and a second hole 152b that is concentric with the first hole 151b, is located below the first hole 151b, and has a small diameter. The movable suction device 30 is attached to an area in which the through hole 15b is formed, so as to be detachable, i.e. replaceable. Note that the movable suction device 30 is connected to the suction source via a suction system other than the suction system connected to the grooves 11a to 15a formed in the mounting platforms 11 to 15.

The movable suction device 30 includes a flange member 31, a cylinder 32, a coil spring 33, and a restriction mechanism 34.

As shown in FIG. 2, the flange member 31 includes a body 311, an attachment portion 312 that is formed integrally with an upper end portion of the body 311 and has a disc-like shape, and a connector portion 313 that is provided at a lower end portion of the body 311. The body 311 is inserted into the second hole 152b in the fifth mounting platform 15, and the attachment portion 312 is inserted into the first hole 151b in the fifth mounting platform 15.

A housing portion 31a that extends in the vertical direction is formed inside the body 311 and the attachment portion 312. The top of the housing portion 31a is open. Also, the bottom of the housing portion 31a is provided with a screw hole 31b to which the connector portion 313 is attached, and a communication hole 31c that is in communication with the suction source via the connector portion 313. The housing portion 31a has a circular cross section along the entire length thereof in the vertical direction. The attachment portion 312 is provided with a plurality of holes 312a for attachment to the fifth mounting platform 15. The movable suction device 30 is fixed to a through hole 15b in the fifth mounting platform 15 by bolts 36 that penetrate through the holes 312a.

The cylinder 32 is housed in the housing portion 31a of the flange member 31 so as to be movable in the vertical direction within a predetermined range. The cylinder 32 includes a cylinder body 321 that has a cylindrical shape, and an abutting member 322. The cylinder body 321 is made of metal, and has a suction hole 32a formed inside thereof, which penetrates through the cylinder body 321 in the vertical direction. Preferably, a gap between the inner circumferential surface of the housing portion 31a of the flange member 31 and the outer circumferential surface of the cylinder body 321 is no greater than 50 µm. If the gap is greater than 50 µm, external air is likely to enter from this gap when suction is performed, which leads to insufficient suction power. The abutting member 322 is a member that is made of a resin and has a hole that penetrates through a central portion thereof, and is attached to the cylinder body 321 so as to cover the top of the cylinder body 321. As the resin used to form the abutting member 322, it is desirable to select a material that has a lower hardness than substrates (e.g. glass substrates), and has a small coefficient of friction with substrates so that the abutting member 322 does not scratch substrates, for example.

The coil spring 33 is housed in the housing portion 31a of the flange member 31. The upper end of the coil spring 33 abuts against the lower end surface of the cylinder 32, and the lower end of the coil spring 33 abuts against the bottom surface of the housing portion 31a. Thus, the coil spring 33 constantly biases the cylinder 32 upward. Note that the greater the spring constant of the coil spring 33 is, the less likely the cylinder 32 is to move downward in a state where a substrate is not sucked. On the other hand, the biasing force of the coil spring 33 acts as a force that opposes the downward movement of the cylinder 32, and prevents the cylinder 32 from moving downward. Thus, in order to reliably move the cylinder 32 downward while sucking a substrate (while straightening out a warped substrate), it is preferable that the spring constant of the coil spring 33 is small. Therefore, the ratio of the inner diameter to the outer diameter of the cylinder 32 is set to be small so that a suction force that acts on the cylinder 32 is small, and thus, despite the coil spring 33 with a small spring constant being used, the cylinder 32 is prevented from easily moving downward in a state where a substrate is not sucked by the cylinder 32.

The restriction mechanism 34 is a mechanism for restricting the amount of protrusion of the upper end surface of the cylinder 32 protruding from the mounting surface of the fifth mounting platform 15 to, for example, 5 mm. The restriction mechanism 34 includes a plurality of elongated holes 32b that are formed in the cylinder 32, a pin 38, and a plurality of screw members 39.

As shown in FIG. 2, the elongated holes 32b included in the restriction mechanism 34 are formed in a lower portion of the cylinder 32 and have a predetermined length in the vertical direction. The pin 38 penetrates through holes that are formed in the flange member 31, in a horizontal direction, and also penetrates through the elongated holes 32b in the cylinder 32. The screw members 39 are screwed into screw holes that are formed in the body 311 of the flange member 31 so as to penetrate through the body 311 in a horizontal direction. Due to the screw members 39 being attached, the pin 38 is prevented from coming loose from the holes in the flange member 31 or the elongated holes 32b in the cylinder 32.

The above-described restriction mechanism 34 allows the cylinder 32 to move in the vertical direction within the range defined by the elongated holes 32b. According to the present embodiment, the cylinder 32 is biased upward by the coil spring 33, while, upon the leading end surface (the suction surface) of the cylinder 32 protruding from the mounting surface of the fifth mounting platform 15 by, for example, 5 mm, the cylinder 32 is restricted by the restriction mechanism 34 from moving upward.

### Operations

Upon a substrate being conveyed onto the work table 10, a vacuum pump or the like is activated. In a suction step, only the suction system connected to the movable suction devices 30 is depressurized, and the suction system connected to the grooves 11a to 15a formed in the mounting platforms 11 to 15 is not depressurized, so that only the movable suction devices 30 are activated first.

Thus, only the movable suction devices 30 subject the substrate to vacuum suction. Specifically, when a warped substrate is mounted on the work table 10, the leading end surface of the cylinder 32 (the upper end surface of the abutting member 322) abuts against or comes close to the back surface of the substrate, which is raised above the mounting surface of the work table 10. Then, in such a state, upon the internal spaces of the flange member 31 and the cylinder 32 being depressurized, the substrate is sucked to the upper surface of the cylinder 32 because atmospheric pressure acts on the top surface of the substrate. Upon the substrate being sucked by the cylinder 32, the internal space of the cylinder 32 is closed by the substrate, and a suction force that acts on the cylinder 32 increases. Since the cylinder 32 is movable in the vertical direction, the cylinder 32 moves downward, opposing the biasing force of the coil spring 33. Therefore, the substrate is drawn downward in a state of being sucked by the cylinder 32, to abut against the mounting surface of the work table 10.

Through the above-described operations, even if a substrate is deflected due to warping, undulation, or the like, the substrate can be sucked and fixed to the work table 10 so as to be flat. After the movable suction device 30 sucks and fixes the substrate to the work table 10, the suction system is switched. That is, the suction system connected to the grooves 11a to 15a formed in the mounting platforms 11 to 15 is depressurized, and the depressurization of the suction system connected to the movable suction devices 30 is cancelled. As a result, while operations performed by the movable suction devices 30 to suck the substrate are stopped, the entirety of the substrate is sucked by the grooves 11a to 15a formed in the mounting platforms 11 to 15. Therefore, the entirety of the substrate uniformly abuts against the mounting surface of the work table 10. The substrate is processed in such a state, and thus processing quality can be prevented from being degraded.

### Other Embodiments

The present invention is not limited to the above-described embodiment, and various variations and modifications may be made without departing from the scope of the present invention.
(a) In the above-described embodiment, a coil spring is used as a means for biasing the cylinder upward. However, a means for biasing the cylinder upward is not limited to a coil spring.
(b) Elongated holes, a pin, and screw members are used in a restriction mechanism for restricting the cylinder from moving upward. However, the configuration of the restriction mechanism is not limited to the above-described embodiment.
(c) The shape and number of grooves formed in each mounting platform, and the location and number of movable suction devices, are not limited to those of the above-described embodiment.

### Reference Signs List

- 10:: Work Table
- 11 - 15:: Mounting Platform
- 11a - 15a:: Groove
- 15b:: Through Hole
- 30:: Movable Suction Device
- 31:: Flange Member
- 32:: Cylinder
- 32b:: Elongated Hole (included in Restriction Mechanism)
- 33:: Coil Spring
- 34:: Restriction Mechanism
- 38:: Pin
- 39:: Screw Member

## Claims

1. A substrate suction device that is attachable to and detachable from each of a plurality of holes formed in a work table, and is used to suck a substrate mounted on the work table, the substrate suction device comprising:
a flange member including a housing portion that is formed inside thereof and is open upward, the flange member having a communication hole that is formed in a bottom of the housing portion and is in communication with a suction source, and the flange member being attachable to and detachable from a hole formed in the work table;
a cylinder being located in the housing portion of the flange member so as to be movable in a vertical direction within a predetermined range, and the cylinder having a suction hole that is formed inside thereof and penetrates through the flange member in the vertical direction; and
a biasing means biasing the cylinder upward so that an upper end surface of the cylinder protrudes from a mounting surface of the table by a predetermined amount.

2. The substrate suction device according to claim 1,
wherein the cylinder includes:
a cylinder body being made of metal; and
an abutting member being made of resin, the abutting member being attached to a top portion of the cylinder body, and the abutting member abutting against a workpiece that is to be mounted on the work table.

3. The substrate suction device according to claim 2,
wherein the flange member is made of metal, and
a gap between an inner circumferential surface of the housing portion of the flange member and an outer circumferential surface of the cylinder body is no greater than 50 µm.

4. The substrate suction device according to any one of claims 1 to 3, further comprising:
a restriction mechanism restricting an amount of protrusion of the upper end surface of the cylinder protruding from the mounting surface of the work table.

5. The substrate suction device according to claim 4,
wherein the restriction mechanism includes:
a hole being formed in the cylinder and having a predetermined length in the vertical direction; and
a pin being provided in the flange member and abutting against upper and lower end surfaces of the hole when the cylinder moves upward and downward.

6. A work table for a substrate processing device, a substrate that is to be processed being mounted on the work table, and the substrate processing device sucking and holding the substrate mounted on the work table, the work table comprising:
a table body having a top surface in which grooves that are in communication with a suction source are formed, and is configured to suck and hold a substrate to a mounting surface thereof via the grooves; and
movable suction devices respectively including a cylinder that is movable in a vertical direction such that an upper end surface of the cylinder protrudes from the mounting surface of the table body and is configured to suck a substrate, and being respectively located at a plurality of positions of the table body.

7. The work table according to claim 6, wherein the grooves are formed so as to surround the movable suction devices.

8. The work table according to claim 6 or 7,
wherein holes are formed in the table body, and
each movable suction device includes:
a flange member including a housing portion that is formed inside thereof and is open upward, the flange member having a communication hole that is formed in a bottom of the housing portion and is in communication with a suction source, and the flange member being attachable to and detachable from a hole formed in the table body;
a cylinder being located in the housing portion of the flange member so as to be movable in a vertical direction within a predetermined range, and the cylinder having a suction hole that is formed inside thereof and penetrates through the flange member in the vertical direction; and
a biasing means biasing the cylinder upward so that an upper end surface of the cylinder protrudes from the mounting surface of the table body by a predetermined amount.
